# Europäisches Patentamt
## European Patent Office
## Office européen des brevets

(11) Publication number: **0 107 039**
**B1**

## EUROPEAN PATENT SPECIFICATION

(45) Date of publication of patent specification: **16.01.91**

(51) Int. Cl.⁵: **H 01 L 29/80**

(21) Application number: **83109323.2**

(22) Date of filing: **20.09.83**

(54) Resonant transmission semiconductor device and circuit including such a device.

(30) Priority: **30.09.82 US 429647**

(43) Date of publication of application:
**02.05.84 Bulletin 84/18**

(45) Publication of the grant of the patent:
**16.01.91 Bulletin 91/03**

(84) Designated Contracting States:
**DE FR GB**

(56) References cited:
**EP-A-0 066 675**
**EP-A-0 068 064**
**US-A-4 358 340**

**IBM TECHNICAL DISCLOSURE BULLETIN, vol. 13, no. 12, May 1971, pages 3791-3792, New York, US; R.B. LAIBOWITZ et al.: "Four-terminal field-effect device"**

**BULLETIN OF THE AMERICAN PHYSICAL SOCIETY, vol. 22, 1977, page 407, New York, US; R.T. BATE: "Electrically controllable superlattice"**

(73) Proprietor: **International Business Machines Corporation**
**Old Orchard Road**
**Armonk, N.Y. 10504 (US)**

(72) Inventor: **Fowler, Alan Bicksler**
**3511 Kamhi Drive**
**Yorktown Heights N.Y. 10598 (US)**
Inventor: **Hartstein, Allan Mark**
**5 Deborah Lane**
**Chappaqua New York 10514 (US)**

(74) Representative: **Bailey, Geoffrey Alan**
**IBM United Kingdom Limited Intellectual Property Department Hursley Park**
**Winchester Hampshire SO21 2JN (GB)**

(56) References cited:

**PHYSICA STATUS SOLIDI, vol. 106, no. 63, 1981, pages 63-71, Berlin, DE; D.K. FERRY: "Charge instabilities in lateral super-lattices under conditions of population inversion"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 107 039 B1**

(56) References cited:

SURFACE SCIENCE, vol. 113, 1982, pages 485-488, North-Holland Publishing Co., NL; G.J. IAFRATE: "Lateral (two-dimensional) superlattices: quantum-well confinement and charge instabilities"

APPLIED PHYSICS LETTERS, vol. 24, no. 12, 15th June 1974, pages 593-595, American Institute of Physics, New York, US; L.L. CHANG et al.: "Resonant tunneling in semiconductor double barriers"

IBM TECHNICAL DISCLOSURE BULLETIN, vol. 21, no. 1, June 1978, pages 86-87, New York, US; H.S. LEE: "Inversion charge transistor"

# EP 0 107 039 B1

**Description**

This invention relates to a semiconductor device in which electrical current flows by resonant quantum mechanical transmission.

As the performance of high speed semiconductor switching devices approaches speeds of $10^{-9}$ seconds, the conventional mode of carrier transport involving minority carrier diffusion requires a time that is becoming an increasingly significant limitation.

One approach to avoiding the minority carrier transport time limitation has been to build devices that rely on carrier flow using the mechanism of resonant quantum mechanical transmission through multiple barriers.

Resonant quantum mechanical transmission has been reported in Applied Physics Letters *24*, 12, 15 June 1974, as a physical mechanism that could be employed to produce a particularly high speed type of device. One type of device employing this physical mechanism is described in European Patent application A1-0068064. That device has three contiguous layer regions of the same conductivity type semiconductor material with two identical barriers between the external layers and the internal layer.

There is described in the article on pages 86 and 87 of the IBM Technical Disclosure Bulletin Volume 21 Number 1 (June 1978), a transistor comprising first and second semiconductor electrode regions separated by a channel region in a surface layer of a semiconductor substrate, an inner gate electrode lying over a central portion of the channel region and separated by insulating material from the surface layer of the substrate and an outer gate electrode extending completely over the channel region and separated by insulating material from both the channel region and the inner gate electrode. This transistor operates in the conventional minority carrier diffusion mode.

IBM TECHNICAL DISCLOSURE BULLETIN, Vol. 13, no. 12, May 1971, pages 3791—3792, New York, US; R. B. LAIBOWITZ et al.: "Four-terminal field-effect device" discloses a device comprising first and second semiconductor electrode regions separated by a conduction channel in a surface layer of a semiconductor substrate. Inner gate electrode means having the form of a metal grating extends over the conduction channel and is separated by a thin layer of insulating material from the surface layer of the substrate. An outer gate electrode also extends over the conduction channel and is separated by a relatively thick layer of insulating material from both the conduction channel and the inner gate electrode means.

The invention seeks to provide a semiconductor device which has a structure having some general similarity to that disclosed in the aforementioned IBM Technical Disclosure Bulletin articles, but which is designed to be capable of operating in a resonant quantum mechanical transmission mode.

A semiconductor device comprising first and second semiconductor electrode regions separated by a conduction channel in a surface layer of a semiconductor substrate, inner gate electrode means lying over a central portion of the conduction channel and separated by insulating material from the surface layer of the substrate and an outer gate electrode extending completely over the conduction channel and separated by insulating material from both the conduction channel and the inner gate electrode means, is characterised, according to one aspect of the invention, by the inner gate electrode means consisting of a single gate electrode having a dimension of from 10 to 20 nm in the direction parallel to the conduction channel, by the insulating material between the inner gate electrode means and the conduction channel being from 10 to 20 nm thick and by the insulating material between the outer gate electrode and the conduction channel being approximately twice as thick as the insulating material between the inner gate electrode means and the conduction channel, whereby by individually biasing the single inner gate electrode and the outer gate electrode with respect to the substrate resonant transmission of electric current can occur through the conduction channel between the first and second semiconductor electrode regions.

A semiconductor device comprising first and second semiconductor electrode regions separated by a conduction channel in a surface layer of a semiconductor substrate, inner gate electrode means lying over a central portion of the conduction channel and separated by insulating material from the surface layer of the substrate and an outer gate electrode extending completely over the conduction channel and separated by insulating material from both the conduction channel and the inner gate electrode means, is characterised, according to another aspect of the invention, by the inner gate electrode means consisting of at least two closely spaced electrodes, the electrodes being separated by a distance of 10 to 100 nm and each electrode being 15 to 100 nm across, by the insulating material between the inner gate electrode means and the conduction channel being from 10 to 20 nm thick, by the insulating material between the outer gate electrode and the conduction channel being approximately twice as thick as the insulating material between the inner gate electrode means and the conduction channel, and by the thickness of the insulating material between the outer gate electrode and the portions of the conduction channel other than the central portion thereof is substantially equal to the thickness of the insulating material between the inner gate electrode means and the central portion of the conduction channel, whereby by individually biasing the inner gate electrode means and the outer gate electrode with respect to the substrate resonant transmission of electric current can occur through the conduction channel between the first and second semiconductor electrode regions.

How the invention can be carried out will now be described by way of example, with reference to the accompanying drawings, in which:—

FIG. 1 represents one device embodying the invention;

FIGS. 2 and 3 are energy level diagrams dimensionally correlated with FIG. 1, indicating the presence of a potential well when the device of FIG. 1 is under the influence of bias;

FIG. 4 represents another device embodying the invention;

FIG. 5 is an energy level diagram dimensionally correlated with the structure of FIG. 4, illustrating the barriers and potential well when the device of FIG. 1 is under the influence of bias; and

FIGS. 6, 7, 8 and 9 represent successive stages in the production of the device of FIG. 4.

There follows a description of semiconductor devices which employ the resonant transmission physical mechanism for conduction in a planar surface region between high conductivity electrodes in a semiconductor crystal. The barriers and potential well for the resonant transmission physical mechanism are achieved through a combination of insulating layer thickness dimensions, small gate width and spacing dimensions and an overlapping larger gate and application of potentials between the two gate regions.

The structure of devices according to the invention may be compared with a field effect transistor wherein carrier conduction takes place in a channel which is a region of a semiconductor adjacent a surface between two high conductivity electrode regions called a source and a drain.

In devices according to the invention, a potential well is produced between at least two reflecting barriers penetrating the carrier conduction channel by providing a narrow gate in the layer over the carrier conduction channel and a broad gate over the layer that overlaps the source and drain and the narrow gate. A bias voltage applied to the broad gate sets a barrier level and within that level a different bias voltage applied to the narrow gate operates to produce a potential well.

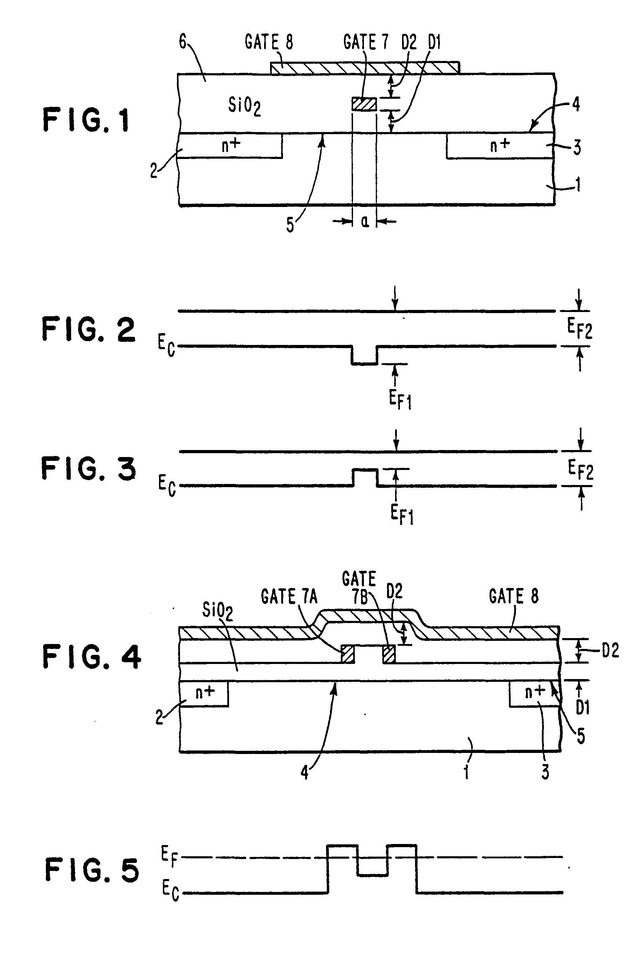

Referring to FIG. 1, a semiconductor body 1 of silicon, for example, is provided. For purposes of illustration, a particular conductivity type will be assigned although to one skilled in the art the transition to the opposite conductivity type arrangement can be readily achieved. In the region 1, the p-type conductivity is assigned. High conductivity type external contact regions 2 and 3, serve the general function of the source and drain type contacts in field effect transistors. The contacts 2 and 3 are at each end of a portion of the p region extending along the surface 4 of the crystal 1 in an area 5 similar to the channel in a conventional field effect transistor. Over the surface 4 of the original body 1, a region of insulating material 6 such as $SiO_2$ is provided. Within the region substantially centered over the channel region 4, a small area gate 7 is provided. The gate 7 is separated from the channel region 4 by a distance D1. A second broader area gate 8 that overlaps the source 2 and drain 3 is provided over the surface of the insulating material 6 separated from the gate 7 by a distance D2. The dimension a of the gate 7 and distances D1 and D2 are of the order of 100 to 200Å (10Å = 1 nm).

Where, for example, the structure involves GaAs as the substrate 1 and GaAlAs as the material 6 and the channel 5 is a modulation doped carrier conductivity region, the mean free path is longer and the mass is lighter than in the silicon example and the dimension a of the gate 7 can be larger. The modulation doped conductivity channel is a region adjacent to an interface with a different semiconductor so that electrons associated with doping in one semiconductor provide carriers in the adjacent semiconductor without the reduced mobility due to collisions with doping atoms. The field in this invention will modulate the conductivity at this type of interface.

The structure of FIG. 1 can be made by a variety of techniques known in the semiconductor industry and a preferred technique is disclosed in published European Patent application No. A1-0066675, wherein in essence a step is made in the insulating material and a diagonal deposition of metal which serves as the gate 7 is placed against the side of the step and thereafter another insulating material growth takes place.

The resonant transmission in devices according to the invention, is achieved through the small size of the gate 7 and the ability to vary independently voltages on gate 7 and gate 8. The performance is described in connection with FIGS. 2 and 3 which are energy level diagrams under the influence of bias. In FIGS. 2 and 3, $E_C$ is the conduction band edge and $E_{F1}$ and $E_{F2}$ are the Fermi energies above the conduction band edge for the regions under gate 7 depending on the biases on gate 7 in relation to gate 8. The potentials are idealized.

In the structure of Fig. 1 the barrier length must be less than the mean free path of a carrier.

The following discussion uses as an approximation a one-dimensional condition although one skilled in the art in the light of the principles set forth will readily extend those principles to a two-dimensional structure.

Considering first the condition of FIG. 2, the transmission coefficient for an electron at the Fermi surface below gate 8 past the potential well is as expressed by Equation 1.

$$\text{Eq. 1} \qquad T = \left[ 1 + \frac{(E_{F2} - E_{F1})^2 \sin^2 \alpha a}{4 E_{F2} E_{F1}} \right]^{-1}$$

where a is the length of the barrier, and

$$\alpha = \left[ \frac{2m^{(E_{F1})}}{\hbar^2} \right]^{1/2}$$

where m is the effective mass of the carrier (electron) parallel to the surface and

$$\text{where } \hbar \text{ is } \frac{\text{Planck's constant}}{2\pi}$$

Under the conditions of Equation 1, the maximum T would be 1 and the minimum would be of the order of 0.2 where $E_{F1}$ is equal to 70 meV and $E_{F2}$ is of the order of 4 meV. As an example a is 200 Angstroms.

Under these conditions, the transmission would fluctuate because the $\sin^2\alpha a$ term of Equation 1, the minima and maxima of T, have been found to occur with a period given by $\alpha a = \pi$. Thus, if $E_{F1}$ is varied by 3.8 millielectron volts (meV), for the above example the transmission will go through a minimum and return to a maximum. Where the distance D1 under gate 7 is of the order of 200 Angstroms and the distance D2 between gate 7 and gate 8 is about 200 Angstroms, a change at gate 7 of 0.5 volts is required to effect a change whereas if D1 is reduced to about 100 Angstroms, only 0.25 volts is required.

Referring next to FIG. 3, the relative potentials on gates 7 and 8 are such that $E_{F1}$ under gate 7 is less than $E_{F2}$. The transmission T obeys the law of Equation 1 but now T will only be small when $E_{F1}$ is small. The first resonance will occur for $\alpha a = \pi/2$. Under conditions where a is equal to 200 Angstroms, $E_{F1}$ would be 1.17 meV. If $E_{F2}$ were to be 50 meV, then T would be equal to 0.09.

In a majority carrier type device there is particular sensitivity to series resistance. One advantage of the arrangement of FIG. 2 is that series resistance is less.

The series resistance of this type of structure is governed by the expression of Equation 2.

$$\text{Eq. 2} \quad \frac{1}{R_S} = e\, n_{s2}\, \mu\, \frac{W}{L} \stackrel{\sim}{\approx} \frac{1}{250} \quad \text{ohm}^{-1}$$

For an example set of conditions where (W) Width = (L) Length and where
  e is electron charge
  $n_{s2}$ is carrier density at the surface
  $\mu$ is the mobility of the carriers

The conductance for a single barrier can be established through the Landauer formula as published in the Zeitschrift der Physik B 247, 1975, and set forth in Equation 3.

$$\text{Eq. 3} \quad G = \frac{e^2}{2} \left( \frac{\hbar\, k}{m} \right) \frac{T}{1-T} \frac{1}{dE_{F2}/dn_{s2}}$$

where

  h is Planck's constant
  k is wave vector in the region adjacent to the barrier
  m is effective mass of the carrier (electron)
  $E_{F2}$ is Fermi energy in region adjacent the barrier

Under these circumstances for the energy conditions of FIG. 2, R would be equal to 260 ohms. Thus, the resistance of the barrier can be of the order of the series resistance and meaningful modulation can be accomplished.

The gain of devices embodying the invention is large. In the energy condition of FIG. 2, the shift in energy is about 1 meV. This corresponds to about $1.6 \times 10^{11}$ carriers per square centimeter. For a distance D1 of approximately 100 Angstroms this would require less than 0.1 volt with the transconductance ($G_m$) being about 1/25 which is extremely large when it is considered that the example has a width to length ratio of 1.

The device under the energy conditions of FIG. 2 in the absence of special measures will remain on. Such a structure would be useful as a linear amplifier.

For the energy conditions of FIG. 3, there will be many resonances of comparable depth and where bias voltages are arranged to swing through all of them, the structure can serve as a frequency multiplier.

There will be structural variations such as the providing of a grating of steps placed in the gate area 5 so that the gain of the device would be increased because as set forth in connection with Equation 5 the resistance would have to be multiplied by the number of narrow gates or wells. This would improve the ratio of the barrier resistance to the series resistance.

A further structural variation would occur if the width of the device were to be decreased to produce a width to length ratio of 1. This would cause the series resistance to be unchanged but the barrier resistance to increase.

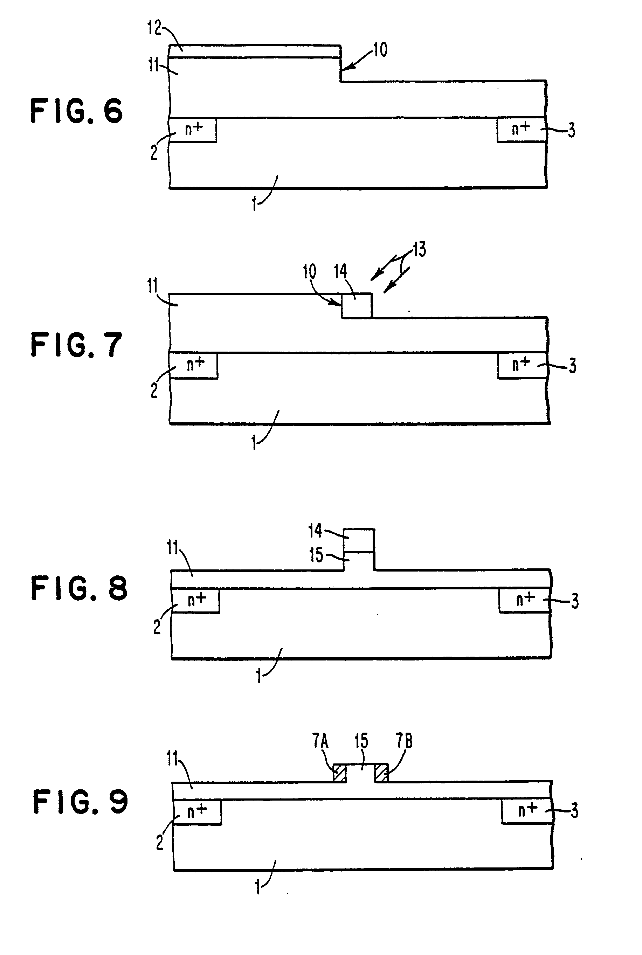

In accordance with the principles of the invention, the use of multiple small gates will produce a potential well between them as shown in FIGS. 4 and 5.

Referring next to FIG. 4, this condition is illustrated wherein the structure is shown with the same reference numerals for elements with similar functions. Here however the gate 7 of FIG. 1 is now made in two parts, 7A and 7B, and the gate 8 is farther away from the channel 4 only over the gate 7. The dimension D2 between the gate 8 and the gate 7 is thus substantially the same from the top of gate 7 to gate 8 over gate 7 and from gate 8 to the channel 4.

Under these conditions, a bias on the gate 8 is changed by the multi-part gate 7A and 7B and positions the band level above the Fermi level under each portion of the gate providing the potential well under the oxide between them as shown in the dimensionally correlated energy diagram of FIG. 5.

The structure of FIG. 4 can be achieved by using an edge deposited metal member which can be of a dimension of the order of 100 to 1000Å as a mask in the formation of a mesa and then edge depositing the members 7A and 7B on each side. A process for producing the structure of FIG. 4 is illustrated in connection with FIGS. 6, 7 and 8 wherein like reference numerals are used as in FIG. 4.

Referring to FIG. 6, a step 10 in the layer 11, such as SiO$_2$, is formed by masking with a Reactive Ion Etch (RIE) resist 12, such as Al, and then using RIE to remove the unmasked material to the desired depth. Alternatively, all unmasked oxide can be removed and then a selected area of oxide regrown to produce the structure in FIG. 6.

Referring to FIG. 7, after dip etch removal of the mask 12 of FIG. 6, using a deposition from an angle such as 70° as shown by arrows 13, an RIE mask 14 of such as Al is formed. The angle deposition provides a thicker deposit on the vertical and a thinner deposit on the horizontal. FIG. 7 shows the structure after etching off the deposited material on the horizontal.

In FIG. 8, RIE is used to provide a mesa 15 by the partial removal of the layer 11 where not masked by the member 14. Similarly, an alternative is that all unmasked oxide can be removed and an area of oxide regrown to produce the structure in FIG. 8.

In FIG. 9, after the member 14 has been etched away, an edge deposition on each side of the mesa 15 produces the gates 7A and 7B.

An additional growth step to produce an oxide thickness equal to the distance D2 will permit a gate 8 to be deposited that will be the same distance D2 over both the substrate and over the gates 7A and 7B.

The separation of the parts 7A and 7B of the split gate can be of the order of 100 Angstroms to 1,000 Angstroms and the thickness of each part 7A and 7B of the split gate can be of the order of 150 to 1,000 Angstroms.

Under biasing conditions wherein gate 8 is subjected to bias and the split gate 7A and 7B is biased differently from gate 8, the energy band diagram is as shown in FIG. 5. It should be noted in connection with FIG. 5 that the conduction band edge under the split gate region can take on any level produced by the gate voltage conditions. The widths of all the barriers and the well can be chosen by the physical sizes of the gates, the processing and the dimensions D1 and D2. The Fermi level energy is controlled by the gate voltage on gate 8 whereas the height of the barriers is controlled by a gate voltage on the split gate 7.

In this structure, electron transmission through the device will show resonances as the electron wavelength varies in the central quantum or potential well in FIG. 5. Both the voltage on the split gate 7A and 7B and on the overlapping gate 8 will control the resonance conditions. The transmission and hence the device resistance will oscillate as various standing wave conditions are met in the central well region. The structure of FIG. 4 is thus particularly useful both as a high speed of response amplifier and as a frequency multiplier.

**Claims**

1. A semiconductor device comprising first and second semiconductor electrode regions (2, 3) separated by a conduction channel (5) in a surface layer (4) of a semiconductor substrate (1), inner gate electrode means (7) lying over a central portion of the conduction channel (5) and separated (D1) by insulating material form the surface layer (4) of the substrate and an outer gate electrode (8) extending completely over the conduction channel (5) and separated (D2) by insulating material from both the conduction channel (5) and the inner gate electrode means (7), the device being characterised by the inner gate electrode means consisting of a single gate electrode (7) having a dimension of from 10 to 20 nm in the direction parallel to the conduction channel, by the insulating material between the inner gate electrode means and the conduction channel being from 10 to 20 nm thick and by the insulating material between the outer gate electrode and the conduction channel being approximately twice as thick as the insulating material between the inner gate electrode means and the conduction channel, whereby by individually biasing the single inner gate electrode (7) and the outer gate electrode (8) with respect to the substrate (1) resonant transmission of electric current can occur through the conduction channel (5) between the first and second semiconductor electrode regions (2, 3).

2. A semiconductor device comprising first and second semiconductor electrode regions (2, 3) separated by a conduction channel (5) in a surface layer (4) of a semiconductor substrate (1), inner gate electrode means (7A; 7B) lying over a central portion of the conduction channel (5) and separated (D1) by insulating material from the surface layer (4) of the substrate and an outer gate electrode (8) extending completely over the conduction channel (5) and separated (D2) by insulating material from both the conduction channel (5) and the inner gate electrode means (7A, 7B), the device being characterised by the inner gate electrode means consisting of at least two closely spaced electrodes (7A, 7B), the electrodes being separated by a distance of 10 to 100 nm and each electrode being 15 to 100 nm across, by the insulating material between the inner gate electrode means and the conduction channel being from 10 to 20 nm thick, by the insulating material between the outer gate electrode and the conduction channel being approximately twice as thick as the insulating material between the inner gate electrode means and the conduction channel, and by the thickness of the insulating material between the outer gate electrode and the portions of the conduction channel other than the central portion thereof is substantially equal to the thickness of the insulating material between the inner gate electrode means and the central portion of the conduction channel, whereby by individually biasing the inner gate electrode means (7A, 7B) and the outer gate electrode (8) with respect to the substrate (1) resonant transmission of electric current can occur through the conduction channel (5) between the first and second semiconductor electrode regions (2, 3).

3. A semiconductor device as claimed in claim 2, in which the inner gate electrode means is produced by forming a step in the insulating material over the conduction channel at the intended location of the inner gate electrode means, edge depositing a masking material against the step in the insulating material, vertically etching away the insulating material except where it is protected by the masking material so as to form a mesa in the insulating material, and edge depositing conductive material on each side of the mesa of insulating material.

4. A semiconductor device as claimed in any preceding claim, in which the semiconductor substrate consists of silicon.

5. A semiconductor device as claimed in any of claims 1 to 3, in which the semiconductor substrate consists of GaAs and the insulating material between the conduction channel, the inner gate electrode means and the outer gate electrode consists of GaAlAs.

6. A circuit including a semiconductor device as claimed in any preceding claim and a source of a first bias voltage connected to the inner gate electrode means and a source of a second bias voltage connected to the outer gate electrode, the first and second bias voltages being such that the bias applied to the inner gate electrode means enhances the effect of the bias applied to the outer gate electrode.

7. A circuit including a semiconductor device as claimed in any of claims 1 to 5, and a source of a first bias voltage connected to the inner gate electrode means and a source of a second bias voltage connected to the outer gate electrode, the first and second bias voltages being such that the bias applied to the inner gate electrode means opposes the effect of the bias applied to the outer gate electrode.

**Patentansprüche**

1. Halbleiterbauelement mit ersten und zweiten Halbleiterlektroden-Bereichen (2, 3), die durch einen Leitungskanal (5) in einer Oberflächenschicht (4) eines Halbleitersubstrates (1) getrennt sind, mit einem inneren Gate-Elektrodemittel (7), das über einem zentralen Abschnitt des Leitungskanales (5) liegt und durch ein isolierendes Material von der Oberflächenschicht (4) des Substrates getrennt (D1) ist und mit einer äußeren Gate-Elektrode (8), die sich vollständig über dem Leitungskanal (5) erstreckt und durch ein isolierendes Material sowohl von dem Leitungskanal (5) als auch von dem inneren Gate-Elektrodemittel (7) getrennt (D2) ist, wobei das Bauelement gekennzeichnet ist: durch das innere Gate-Elektrodemittel, das aus einer einzigen Gate-Elektrode (7) mit einer Abmessung von 10 bis 20 nm in Richtung parallel zu dem Leitungskanal besteht, durch das isolierende Material zwischen dem inneren Gate-Elektrodemittel und dem Leitungskanal, wobei es von 10 bis 20 nm dick ist und durch das isolierende Material zwischen der äußeren Gate-Elektrode und dem Leitungskanal, wobei es ungefähr zweimal so dick ist, wie das isolierende Material zwischen dem inneren Gate-Elektrodemittel und dem Leistungskanal, sodaß durch einzelnes Vorspannen der einzigen inneren Gate-Elektrode (7) und der äußeren Gate-Elektrode (8) in Bezug auf das Substrat (1) eine resonante Transmission des elektrischen Stromes durch den Leitungskanal (5) zwischen den ersten und zweiten Halbleiterlektroden-Bereichen (2, 3) auftreten kann.

2. Halbleiterbauelement mit ersten und zweiten Halbleiterelektroden-Bereichen (2, 3), die durch einen Leitungskanal (5) in einer Oberflächenschicht (4) eines Halbleitersubstrates (1) getrennt sind, mit einem inneren Gate-Elektrodemittel (7A; 7B), das über einen zentralen Abschnitt des Leitungskanales (5) liegt und durch ein isolierendes Material von der Oberflächenschicht (4) des Substrates getrennt (D1) ist und mit

7

einer äußeren Gate-Elektrode (8), die sich vollständig über dem Leitungskanal (5) erstreckt und durch ein isolierendes Material sowohl von dem Leitungskanal (5) als auch von dem inneren Gate-Elektrodemittel (7A, 7B) getrennt (D2) ist, wobei das Bauelement gekennzeichnet ist: durch das innere Gate-Elektrodemittel, das aus zumindest zwei eng beabstandeten Elektroden (7A, 8B) besteht, wobei die Elektroden durch einen Abstand von 10 bis 100 nm getrennt sind und jede Elektrode 15 bis 100 mm dick ist, durch das isolierende Material zwischen dem inneren Gate-Elektrodemittel und dem Leitungskanal, wobei es von 10 bis 20 nm dick ist, durch das isolierende Material zwischen der äußeren Gate-Elektrode und dem Leitungskanal, wobei es ungefähr zweimal so dick ist, wie das isolierende Material zwischen den inneren Gate-Elektrodemittel und dem Leitungskanal und dadurch, daß die Dicke des isolierenden Materials zwischen der äußeren Gate-Elektrode und den Abschnitten des Leitungskanales, die im Unterschied zu dessen zentralem Abschnitt andere sind, im wesentlichen gleich der Dicke des isolierenden Materials zwischen dem inneren Gate-Elektrodemittel und dem zentralen Abschnitt des Leitungskanales ist, sodaß durch einzelnes Vorspannen des inneren Gate-Elektrodemittels (7A, 7B) und der äußeren Gate-Elektrode (8) in Bezug auf das Substrat (1) eine resonante Transmission des elektrischen Stromes durch den Leitungskanal (5) zwischen den ersten und zweiten Halbleiterelektroden-Bereichen (2, 3) auftreten kann.

3. Halbleiterbauelement nach Anspruch 2, bei welchem das innere Gate-Elektrodemittel durch Ausbilden einer Stufe in dem isolierenden Material über dem Leitungskanal an der beabsichtigten Stelle des inneren Gate-Elektrodemittels, Aufbringen eines Maskenmaterials gegenüber der Stufe in dem isolierenden Material, unter Kantenbildung, vertikales Abätzen des isolierenden Materials, ausgenommen, wo es durch das Maskenmaterial geschützt ist, um eine Mesa in dem isolierenden Material auszubilden und Aufbringen eines Leitermaterials unter Kantenbildung auf jeder Seite der Mesa des isolierenden Materials hergestellt wird.

4. Halbleiterbauelement nach irgend einem vorhergehenden Anspruch, bei welchem das Halbleitersubstrat aus Silizium besteht.

5. Halbleiterbauelement nach einem der Ansprüche 1 bis 3, bei welchem das Halbleitersubstrat aus GaAs besteht und das isolierende Material zwischen dem Leitungskanal, dem inneren Gate-Elektrodenmittel und der äußeren Gate-Elektrode aus GaAlAs besteht.

6. Schaltung mit einem Halbleiterbauelement nach irgendeinem vorhergehenden Anspruch und einer Quelle einer ersten Vorspannung, die an das innere Gate-Elektrodemittel gelegt wird und einer Quelle einer zweiten Vorspannung, die an die äußere Gate-Elektrode gelegt wird, wobei die ersten und zweiten Vorspannungen derart sind, daß die an das innere Gate-Elektrodemittel gelegte Vorspannung den Effekt der an die äußere Gate-Elektrode gelegten Vorspannung erhöht.

7. Schaltung mit einem Halbleiterbauelement nach irgendeinem der Ansprüche 1 bis 5 und einer Quelle einer ersten Vorspannung, die an das innere Gate-Elektrodemittel gelegt wird und einer Quelle einer zweiten Vorspannung, die an die äußere Gate-Elektrode gelegt wird, wobei die ersten und zweiten Vorspannungen derart sind, daß die an das innere Gate-Elektrodemittel gelegte Vorspannung dem Effekt der an die äußere Gate-Elektrode gelegten Vorspannung entgegenwirkt.

**Revendications**

1. Dispositif semi-conducteur comprenant une première et une deuxième régions d'électrodes semi-conductrices (2, 3) séparées par un canal de conduction (5) dans une couche de surface (4) d'un substrat semi-conducteur (1), des moyens d'électrode de grille intérieure (7) situés au-dessus d'une partie centrale du canal de conduction (5) et séparés (D1) par une matière isolante de la couche de surface (4) du substrat, et une électrode de grille extérieure (8) s'étendant complètement au-dessus du canal de conduction (5) et séparée (D2) par une matière isolante à la fois du canal de conduction (5) et des moyens d'électrode de grille intérieure (7), le dispositif étant caractérisé en ce que les moyens d'électrode de grille intérieure consistent en une électrode de grille unique (7) ayant une dimension de 10 à 20 nm dans la direction parallèle au canal de conduction, en ce que la matière isolante entre les moyens d'électrode de grille intérieure et le canal de conduction a une épaisseur de 10 à 20 nm, et en ce que la matière isolante entre l'électrode de grille extérieure et le canal de conduction a une épaisseur sensiblement double de celle de la matière isolante entre les moyens d'électrode de grille intérieure et le canal de conduction, de sorte que, par polarisation individuelle de l'électrode de grille intérieure unique (7) et de l'électrode de grille extérieure (8) par rapport au substrat (1), une transmission résonnante de courant électrique peut se produire par l'intermédiaire du canal de conduction (5) entre les première et deuxième régions d'électrodes semi-conductrices (2, 3).

2. Dispositif semi-conducteur comprenant une première et une deuxième régions d'électrodes semi-conductrices (2, 3) séparées par un canal de conduction (5) dans une couche de surface (4) d'un substrat semi-conducteur (1), des moyens d'électrode de grille intérieure (7A, 7B) situés au-dessus d'une partie centrale du canal de conduction (5) et séparés (D1) par une matière isolante de la couche de surface (4) du substrat, et une électrode de grille extérieure (8) s'étendant complètement au-dessus du canal de conduction (5) et séparée (D2) par une matière isolante à la fois du canal de conduction (5) et des moyens d'électrode de grille intérieure (7A, 7B), le dispositif étant caractérisé en ce que les moyens d'électrode de grille intérieure consistent en au moins deux électrodes peu espacées (7A, 7B), les électrodes étant séparées par une distance de 10 à 100 nm et chaque électrode ayant une largeur de 15 à 100 nm, en ce que la matière isolante entre les moyens d'électrode de grille intérieure et le canal de conduction a une épaisseur de 10 à 20 nm, en ce que la matière isolante entre l'électrode de grille extérieure et le canal de conduction a une épaisseur sensiblement double de celle de la matière isolante entre les moyens d'électrode de grille intérieure et le canal de conduction, et en ce que l'épaisseur de la matière isolante entre l'électrode de grille extérieure et les parties du canal de conduction autres que sa partie centrale est sensiblement égale à l'épaisseur de la matière isolante entre les moyens d'électrode de grille intérieure et la partie centrale du canal de conduction, de sorte que, par polarisation individuelle des moyens d'électrode de grille intérieure (7A, 7B) et de l'électrode de grille extérieure (8) par rapport au substrat (1), une transmission résonante de courant électrique peut se produire par l'intermédiaire du canal de conduction (5) entre les première et deuxième régions d'électrodes semi-conductrices (2, 3).

3. Dispositif semi-conducteur suivant la revendication 2, dans lequel les moyens d'électrode de grille intérieure sont produits par formation d'une marche d'escalier dans la matière isolante au-dessus du canal de conduction à l'endroit prévu des moyens d'électrode de grille intérieure, dépôt latéral d'une matière de masquage contre la marche dans la matière isolante, élimination par attaque verticale de la matière isolante sauf où elle est protégée par la matière de masquage de manière à former une table dans la matière isolante, et dépôt latéral de matière conductrice de chaque côté de la table de matière isolante.

4. Dispositif semi-conducteur suivant l'une quelconque des revendications précédentes, dans lequel le substrat semi-conducteur est en silicium.

5. Dispositif semi-conducteur suivant l'une quelconque des revendications 1 à 3, dans lequel le substrat semi-conducteur est en GaAs et la matière isolante entre le canal de conduction, les moyens d'électrode de grille intérieure et l'électrode de grille extérieure, est en GaAlAs.

6. Circuit comprenant un dispositif semi-conducteur suivant l'une quelconque des revendications précédentes et une source d'une première tension de polarisation connectée aux moyens d'électrode de grille intérieure et une source d'une deuxième tension de polarisation connectée à l'électrode de grille extérieure, les première et deuxième tensions de polarisation étant telles que la polarisation appliquée aux moyens d'électrode de grille intérieure renforce l'effet de la polarisation appliquée à l'électrode de grille extérieure.

7. Circuit comprenant un dispositif semi-conducteur suivant l'une quelconque des revendications 1 à 5 et une source d'une première tension de polarisation connectée aux moyens d'électrode de grille intérieure et une source d'une deuxième tension de polarisation connectée à l'électrode de grille extérieure, la première tension de polarisation et la deuxième tension de polarisation étant telles que la polarisation appliquée aux moyens d'électrode de grille intérieure s'oppose à l'effet de la polarisation appliquée à l'électrode de grille extérieure.

**FIG. 1**

GATE 8    GATE 7  D2  D1

SiO₂

6

n+

4

n+

3

2

1

5

a

**FIG. 2**

$E_C$

$E_{F2}$

$E_{F1}$

**FIG. 3**

$E_C$

$E_{F2}$

$E_{F1}$

**FIG. 4**

GATE
7A

GATE
7B    D2

GATE 8

SiO₂

D2

n+

2

n+

D1

4

5

4

1

3

**FIG. 5**

$E_F$

$E_C$

FIG. 6

FIG. 7

FIG. 8

FIG. 9